# EUROPEAN PATENT APPLICATION

(11) **EP 3 046 401 A1**
(43) Date of publication of application: **20.07.2016**
(21) Application number: 16159092.2
(22) Date of filing: 26.10.2011
(51) Int. Cl.: H05K 3/18, C08K 9/02, C08L 69/00, C08K 3/22, C08L 55/02

(54) **LASER DIRECT STRUCTURING MATERIALS WITH ALL COLOR CAPABILITY**

(30) Priority: 26.10.2010 US 406599 P
(62) Divisional of application: 11785794.6
(71) Applicant: SABIC Global Technologies B.V., 4612 PX Bergen op Zoom (NL)
(72) Inventor: JI, Qiang, Shanghai 201203 (CN); JIANG, Siguang, Shanghai, 201300 (CN); MENG, Jiru, Shanghai 201300 (CN); ZOU, Xiangping, Shanghai 201203 (CN); WU, Tong, Shanghai 200240 (CN)
(74) Representative: Agasse, Stéphane

(57) **Abstract**

Thermoplastic compositions that are capable of being used in a laser direct structuring process to provide enhanced plating performance and good mechanical properties. The compositions include a thermoplastic base resin, a laser direct structuring additive, and a mineral filler. The compositions can be used in a variety of applications such as personal computers, notebook and portable computers, cell phone antennas and other such communications equipment, medical applications, RFID applications, and automotive applications.

## Description

### FIELD OF THE INVENTION

The present invention relates to thermoplastic compositions, and in particular to thermoplastic compositions capable of being used in a laser direct structuring process. The present invention also relates to methods of manufacturing these compositions and articles that include these compositions.

### BACKGROUND OF THE INVENTION

Electrical components may be provided as molded injection devices (MID) with desired printed conductors, i.e., when manufactured in MID technology, using different methods, e.g., a masking method, in two-component injection molding with subsequent electroplating (or electroless plating), because for some cases, chemical plating is used for 2-component injection molding. In contrast to conventional circuit boards made of fiberglass-reinforced plastic or the like, MID components manufactured in this way are three-dimensional molded parts having an integrated printed conductor layout and possibly further electronic or electromechanical components. The use of MID components of this type, even if the components have only printed conductors and are used to replace conventional wiring inside an electrical or electronic device, saves space, allowing the relevant device to be made smaller, and lowers the manufacturing costs by reducing the number of assembly and contacting steps. These MID devices have great utility in cell phones, PDAs and notebook applications.

Stamp metal, flexible printed circuit board (FPCB) mounted and two-shot molding methods are three existing technologies to make an MID. However, stamping and FPCB mounted process have limitations in the pattern geometry, and the tooling is expensive and also altering of a RF pattern causes high-priced and time-consuming modifications into tooling. 2-shot-molding (two-component injection molding) processes have been used to produce 3D-MIDs with real three-dimensional structures. The antenna can be formed with subsequent chemical corrosion, chemical surface activation and selective metal coating. This method involves high initial costs and is only economically viable for large production numbers. 2-shot-molding is also not environmentally friendly process. All these three methods are tool-based technologies, which have limited flexibility, long development cycles, difficult prototype, expensive design changes, and limited miniaturization.

Accordingly, it is becoming increasingly popular to form MIDs using a laser direct structuring (LDS) process. In an LDS process a computer-controlled laser beam travels over the MID to activate the plastic surface at locations where the conductive path is to be situated. With a laser direct structuring process, it is possible to obtain small conductive path widths (such as of 150 microns or less). In addition, the spacing between the conductive paths may also be small. As a result, MIDs formed from this process save space and weight in the end-use applications. Another advantage of laser direct structuring is its flexibility. If the design of the circuit is changed, it is simply a matter of reprogramming the computer that controls the laser.

In addition, the use of prior art LDS additives that are darker in nature prevented the ability of the composition to be colored as desired. The current additives for LDS materials are usually spinel based metal oxide (such as copper chromium oxide), organic metal complexes such as palladium/palladium-containing heavy metal complex or copper complex, there are some limitations based on these additives. Spinel based metal oxide used can only provide black color, which limits the applications for the LDS technology in many areas such as housing antenna, which often requires that the materials to be used should be colorable and colorful. In addition, for organic metal complexes, the relatively higher loading required to obtain sufficiently dense nucleation for rapid metallization when activated by laser radiation, which adversely affects the mechanical properties of the materials.

Accordingly, it would be beneficial to provide a LDS material having a good plating performance while still maintaining good mechanical performance. It would also be beneficial to provide a LDS material composition that is capable of being used in various applications due to the ability of the composition to provide good mechanical performance. It would also be beneficial to provide a thermoplastic composition that is capable of being used in a laser direct structuring process. It would also be beneficial to provide a LDS material composition that is capable of being colored.

### BRIEF SUMMARY OF THE INVENTION

The present invention provides a color thermoplastic composition capable of being used in a laser direct structuring process. The compositions of the present invention include a thermoplastic base resin, a laser direct structuring additive, and optionally a colorant. The compositions can be used in a variety of applications such as personal computers, notebook and portable computers, cell phone antennas and other such communications equipment, medical applications, RFID applications, and automotive applications.

Accordingly, in one aspect, the present invention provides a thermoplastic composition including from 75 to 99.5% by weight of a thermoplastic base resin and from 0.5 to 25% by weight of a metal oxide coated filler; wherein the thermoplastic compositions are capable of being plated after being activated using a laser; wherein the compositions have a L* value as determined by ASTM 2244 from 40 to 85; wherein the compositions have an a* value as determined by ASTM 2244 from -1 to -5; and wherein the compositions have a b* value as determined by ASTM 2244 from -5 to 20.

In another aspect, the present invention provides a method of forming a thermoplastic composition including the step of blending in an extruder 75 to 99.5% by weight of a thermoplastic base resin and from 0.5 to 25% by weight of a metal oxide coated filler; wherein the thermoplastic compositions are capable of being plated after being activated using a laser; wherein the compositions have a L* value as determined by ASTM 2244 from 40 to 85; wherein the compositions have an a* value as determined by ASTM 2244 from -1 to -5; and wherein the compositions have a b* value as determined by ASTM 2244 from -5 to 20.

In still another aspect, the present invention provides a thermoplastic composition including from 70 to 99.4% by weight of a thermoplastic base resin; from 0.5 to 20% by weight of a metal oxide coated filler; and 0.1 to 10% by weight of at least one dye, pigment, colorant or a combination including at least one of the foregoing; wherein the thermoplastic compositions are capable of being plated after being activated using a laser; wherein the thermoplastic compositions have a color space defined by a L* value as determined by ASTM 2244 from 28 to 94, an a* value as determined by ASTM 2244 from -50 to 52; and b* value as determined by ASTM 2244 from -40 to 80.

In yet another aspect, the present invention provides a method of forming a thermoplastic composition including the step of blending in an extruder 70 to 99.4% by weight of a thermoplastic base resin; from 0.5 to 20% by weight of a metal oxide coated filler; and 0.1 to 10% by weight of at least one dye, pigment, colorant or a combination including at least one of the foregoing; wherein the thermoplastic compositions are capable of being plated after being activated using a laser; wherein the thermoplastic compositions have a color space defined by a L* value as determined by ASTM 2244 from 28 to 94, an a* value as determined by ASTM 2244 from -50 to 52; and b* value as determined by ASTM 2244 from -40 to 80.

In still another aspect, the present invention provides an article of manufacture including a molded article having a conductive path thereon and a metal layer plated on the conductive path; wherein the metal layer has a peel strength of 0.3 N/mm or higher as measured according to IPC-TM-650; further wherein the molded article is formed from a composition consisting essentially of from 75 to 99.5% by weight of a thermoplastic base resin; and from 0.5 to 25% by weight of a filler selected from a metal oxide, a metal oxide coated filler, or a combination thereof; wherein the composition has a L* value as determined by ASTM 2244 from 40 to 85; wherein the composition has an a* value as determined by ASTM 2244 from -1 to -5; and wherein the composition has a b* value as determined by ASTM 2244 from -5 to 20.

In yet another aspect, the present invention provides an article of manufacture including a molded article having a conductive path thereon and a metal layer plated on the conductive path; wherein the metal layer has a peel strength of 0.3 N/mm or higher as measured according to IPC-TM-650; further wherein the molded article is formed from a composition consisting essentially of from 70 to 99.4% by weight of a thermoplastic base resin; from 0.5 to 20% by weight of a metal oxide coated filler; and 0.1 to 10% by weight of at least one dye, pigment, colorant or a combination including at least one of the foregoing; wherein the thermoplastic compositions have a color space defined by a L* value as determined by ASTM 2244 from 28 to 94, an a* value as determined by ASTM 2244 from -50 to 52; and b* value as determined by ASTM 2244 from -40 to 80.

In still another aspect, the present invention provides a method of forming an method of forming an article including the steps of molding an article from a composition; using a laser to form a conductive path on the molded article; and plating a copper layer onto the conductive path; wherein the copper layer has a peel strength of 0.3 N/mm or higher as measured according to IPC-TM-650; further wherein the composition consists essentially of from 75 to 99.5% by weight of a thermoplastic base resin; and from 0.5 to 25% by weight of a filler selected from a metal oxide, a metal oxide coated filler, or a combination thereof; wherein the composition has a L* value as determined by ASTM 2244 from 40 to 85; wherein the composition has an a* value as determined by ASTM 2244 from -1 to -5; and wherein the composition has a b* value as determined by ASTM 2244 from -5 to 20.

In yet another aspect, the present invention provides a method of forming an method of forming an article including the steps of molding an article from a composition; using a laser to form a conductive path on the molded article; and plating a copper layer onto the conductive path; wherein the copper layer has a peel strength of 0.3 N/mm or higher as measured according to IPC-TM-650; further wherein the composition consists essentially of from 70 to 99.4% by weight of a thermoplastic base resin; from 0.5 to 20% by weight of a metal oxide coated filler; and 0.1 to 10% by weight of at least one dye, pigment, colorant or a combination including at least one of the foregoing; wherein the thermoplastic compositions have a color space defined by a L* value as determined by ASTM 2244 from 28 to 94, an a* value as determined by ASTM 2244 from -50 to 52; and b* value as determined by ASTM 2244 from -40 to 80.

### DETAILED DESCRIPTION OF THE INVENTION

The present invention provides a colorable thermoplastic composition capable of being used in a laser direct structuring process. The compositions include a thermoplastic resin, metal oxide-coated filler as the laser direct structuring additive and, optionally, a colorant. The thermoplastic compositions do not use a laser direct structuring additive that is dark in color thereby preventing coloration of the composition. However, the thermoplastic compositions also do not use a laser direct structuring additive that must be used in high amounts, thereby damaging mechanical properties. As such, the compositions of the present invention are colorable while retaining mechanical properties through the use of a substrate coated with a metal oxide as the laser direct structuring additive.

Specifically, the present invention provides a new laser direct structuring composition and an article made from the composition that is then used in a laser direct structuring process. The process forms a conductive path on the article that is then plated with metal, such as copper. The compositions of the present invention utilize different laser direct structure additives than prior art materials. These additives still enable copper layers to be plated onto the path formed during the laser direct structuring process. However, unlike prior art LDS additives, these additives result in a composition that can be colored, unlike prior art materials that are too dark to be colorable. As such, the present invention provides compositions and articles that may be a lighter, natural color or, in alternative embodiments, can include a small amount of pigment that enables a wide array of colors to be created while still providing excellent plating performance. This colorable ability is unique as to prior art LDS compositions using prior art LDS additives.

Accordingly, in one aspect, the thermoplastic compositions of the present invention use a thermoplastic resin as the base for the composition. Examples of thermoplastic resins that may be used in the present invention include, but are not limited to, polycarbonate or a polycarbonate/acrylonitrile-butadiene-styrene resin blend; a poly(arylene ether) resin, such as a polyphenylene oxide resin, a nylon-based resin such as a polyphthalamide resin, or a combination including at least one of the foregoing resins.

Accordingly, in one embodiment, the flame retardant thermoplastic composition used a polycarbonate-based resin. The polycarbonate-based resin may be selected from a polycarbonate or a resin blend that includes a polycarbonate. Accordingly, in one embodiment, polycarbonates may be used as the base resin in the composition. Polycarbonates including aromatic carbonate chain units include compositions having structural units of the formula (I): 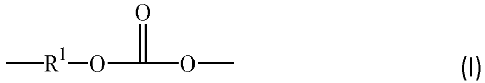 in which the R¹ groups are aromatic, aliphatic or alicyclic radicals. Beneficially, R¹ is an aromatic organic radical and, in an alternative embodiment, a radical of the formula (II): 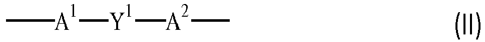 wherein each of A¹ and A² is a monocyclic divalent aryl radical and Y¹ is a bridging radical having zero, one, or two atoms which separate A¹ from A². In an exemplary embodiment, one atom separates A¹ from A². Illustrative examples of radicals of this type are -O-, -S-, -S(O)-, -S(O₂)-, -C(O)-, methylene, cyclohexyl-methylene, 2-[2,2,1]-bicycloheptylidene, ethylidene, isopropylidene, neopentylidene, cyclohexylidene, cyclopentadecylidene, cyclododecylidene, adamantylidene, or the like. In another embodiment, zero atoms separate A¹ from A², with an illustrative example being bisphenol. The bridging radical Y¹ can be a hydrocarbon group or a saturated hydrocarbon group such as methylene, cyclohexylidene or isopropylidene.

Polycarbonates may be produced by the Schotten-Bauman interfacial reaction of the carbonate precursor with dihydroxy compounds. Typically, an aqueous base such as sodium hydroxide, potassium hydroxide, calcium hydroxide, or the like, is mixed with an organic, water immiscible solvent such as benzene, toluene, carbon disulfide, or dichloromethane, which contains the dihydroxy compound. A phase transfer agent is generally used to facilitate the reaction. Molecular weight regulators may be added either singly or in admixture to the reactant mixture. Branching agents, described forthwith may also be added singly or in admixture.

Polycarbonates can be produced by the interfacial reaction polymer precursors such as dihydroxy compounds in which only one atom separates A¹ and A². As used herein, the term "dihydroxy compound" includes, for example, bisphenol compounds having general formula (III) as follows: 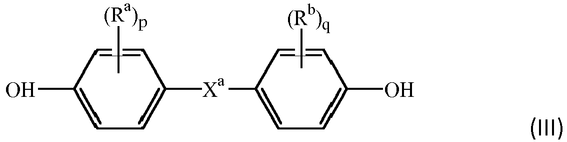 wherein R^{a} and R^{b} each independently represent hydrogen, a halogen atom, or a monovalent hydrocarbon group; p and q are each independently integers from 0 to 4; and X^{a} represents one of the groups of formula (IV): 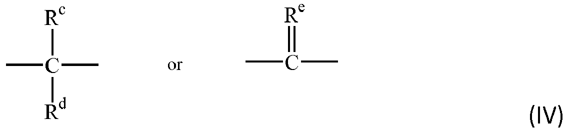 wherein R^{c} and R^{d} each independently represent a hydrogen atom or a monovalent linear or cyclic hydrocarbon group, and R^{e} is a divalent hydrocarbon group.

Examples of the types of bisphenol compounds that may be represented by formula (IV) include the bis(hydroxyaryl)alkane series such as, 1,1-bis(4-hydroxyphenyl)methane, 1,1-bis(4-hydroxyphenyl)ethane, 2,2-bis(4-hydroxyphenyl)propane (or bisphenol-A), 2,2-bis(4-hydroxyphenyl)butane, 2,2-bis(4-hydroxyphenyl)octane, 1,1-bis(4-hydroxyphenyl)propane, 1,1-bis(4-hydroxyphenyl)n-butane, bis(4-hydroxyphenyl)phenylmethane, 2,2-bis(4-hydroxy-1-methylphenyl)propane, 1,1-bis(4-hydroxy-t-butylphenyl)propane, 2,2-bis(4-hydroxy-3-bromophenyl)propane, or the like; bis(hydroxyaryl)cycloalkane series such as, 1,1-bis(4-hydroxyphenyl)cyclopentane, 1,1-bis(4-hydroxyphenyl)cyclohexane, or the like, or combinations including at least one of the foregoing bisphenol compounds.

Other bisphenol compounds that may be represented by formula (III) include those where X is -O-, -S-, -SO- or -SO₂-. Some examples of such bisphenol compounds are bis(hydroxyaryl)ethers such as 4,4'-dihydroxy diphenylether, 4,4'-dihydroxy-3,3'-dimethylphenyl ether, or the like; bis(hydroxy diaryl)sulfides, such as 4,4'-dihydroxy diphenyl sulfide, 4,4'-dihydroxy-3,3'-dimethyl diphenyl sulfide, or the like; bis(hydroxy diaryl) sulfoxides, such as, 4,4'-dihydroxy diphenyl sulfoxides, 4,4'-dihydroxy-3,3'-dimethyl diphenyl sulfoxides, or the like; bis(hydroxy diaryl)sulfones, such as 4,4'-dihydroxy diphenyl sulfone, 4,4'-dihydroxy-3,3'-dimethyl diphenyl sulfone, or the like; or combinations including at least one of the foregoing bisphenol compounds.

Other bisphenol compounds that may be utilized in the polycondensation of polycarbonate are represented by the formula (V) 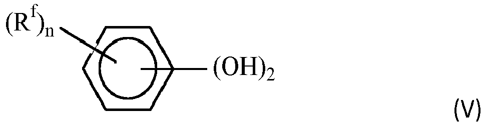 wherein, R^{f}, is a halogen atom of a hydrocarbon group having 1 to 10 carbon atoms or a halogen substituted hydrocarbon group; n is a value from 0 to 4. When n is at least 2, R^{f} may be the same or different. Examples of bisphenol compounds that may be represented by the formula (IV), are resorcinol, substituted resorcinol compounds such as 3-methyl resorcin, 3-ethyl resorcin, 3-propyl resorcin, 3-butyl resorcin, 3-t-butyl resorcin, 3-phenyl resorcin, 3-cumyl resorcin, 2,3,4,6-tetrafloro resorcin, 2,3,4,6-tetrabromo resorcin, or the like; catechol, hydroquinone, substituted hydroquinones, such as 3-methyl hydroquinone, 3-ethyl hydroquinone, 3-propyl hydroquinone, 3-butyl hydroquinone, 3-t-butyl hydroquinone, 3-phenyl hydroquinone, 3-cumyl hydroquinone, 2,3,5,6-tetramethyl hydroquinone, 2,3,5,6-tetra-t-butyl hydroquinone, 2,3,5,6-tetrafloro hydroquinone, 2,3,5,6-tetrabromo hydroquinone, or the like; or combinations including at least one of the foregoing bisphenol compounds.

Bisphenol compounds such as 2,2, 2', 2'- tetrahydro-3, 3, 3', 3'-tetramethyl-1, 1'-spirobi-[IH-indene]-6, 6'- diol represented by the following formula (VI) may also be used.

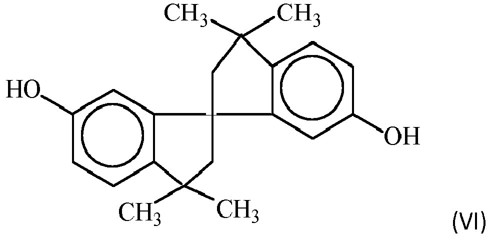

In one embodiment, the bisphenol compound is bisphenol A.

Typical carbonate precursors include the carbonyl halides, for example carbonyl chloride (phosgene), and carbonyl bromide; the bis-haloformates, for example, the bis-haloformates of dihydric phenols such as bisphenol A, hydroquinone, or the like, and the bis-haloformates of glycols such as ethylene glycol and neopentyl glycol; and the diaryl carbonates, such as diphenyl carbonate, di(tolyl) carbonate, and di(naphthyl) carbonate. In one embodiment, the carbonate precursor for the interfacial reaction is carbonyl chloride.

It is also possible to employ polycarbonates resulting from the polymerization of two or more different dihydric phenols or a copolymer of a dihydric phenol with a glycol or with a hydroxy- or acid-terminated polyester or with a dibasic acid or with a hydroxy acid or with an aliphatic diacid in the event a carbonate copolymer rather than a homopolymer is selected for use. Generally, useful aliphatic diacids have about 2 to about 40 carbons. A beneficial aliphatic diacid is dodecanedioic acid.

Branched polycarbonates, as well as blends of linear polycarbonate and a branched polycarbonate may also be used in the composition. The branched polycarbonates may be prepared by adding a branching agent during polymerization. These branching agents may include polyfunctional organic compounds containing at least three functional groups, which may be hydroxyl, carboxyl, carboxylic anhydride, haloformyl, and combinations including at least one of the foregoing branching agents. Specific examples include trimellitic acid, trimellitic anhydride, trimellitic trichloride, tris-p-hydroxy phenyl ethane, isatin-bis-phenol, tris-phenol TC (1,3,5-tris((p-hydroxyphenyl)isopropyl)benzene), tris-phenol PA (4(4(1,1-bis(p-hydroxyphenyl)-ethyl) α,α-dimethyl benzyl)phenol), 4-chloroformyl phthalic anhydride, trimesic acid, benzophenone tetracarboxylic acid, or the like, or combinations including at least one of the foregoing branching agents. The branching agents may be added at a level of about 0.05 to about 2.0 weight percent (wt%), based upon the total weight of the polycarbonate in a given layer.

In one embodiment, the polycarbonate may be produced by a melt polycondensation reaction between a dihydroxy compound and a carbonic acid diester. Examples of the carbonic acid diesters that may be utilized to produce the polycarbonates are diphenyl carbonate, bis(2,4-dichlorophenyl)carbonate, bis(2,4,6-trichlorophenyl) carbonate, bis(2-cyanophenyl) carbonate, bis(o-nitrophenyl) carbonate, ditolyl carbonate, m-cresyl carbonate, dinaphthyl carbonate, bis(diphenyl) carbonate, bis (methylsalicyl)carbonate, diethyl carbonate, dimethyl carbonate, dibutyl carbonate, dicyclohexyl carbonate, or the like, or combinations including at least one of the foregoing carbonic acid diesters. In one embodiment, the carbonic acid diester is diphenyl carbonate or bis (methylsalicyl)carbonate.

Beneficially, the number average molecular weight of the polycarbonate is 3,000 to 1,000,000 grams/mole (g/mole). Within this range, it is beneficial to have a number average molecular weight of greater than or equal to 10,000 in one embodiment, greater than or equal to 20,000 in another embodiment, and greater than or equal to 25,000 g/mole in yet another embodiment. Also beneficial is a number average molecular weight of less than or equal to 100,000 in one embodiment, less than or equal to 75,000 in an alternative embodiment, less than or equal to 50,000 in still another alternative embodiment, and less than or equal to 35, 000 g/mole in yet another alternative embodiment.

In another embodiment, the polycarbonate-based resin used in the thermoplastic composition includes a polycarbonate resin blend, such that a polycarbonate is blended with another resin. In one embodiment, the polycarbonate-based resin includes a blend of a polycarbonate with a polystyrene polymer. Examples include polycarbonate/acrylonitrile-butadiene-styrene resin blends. The term "polystyrene" as used herein includes polymers prepared by bulk, suspension and emulsion polymerization, which contain at least 25% by weight of polymer precursors having structural units derived from a monomer of the formula (VII): 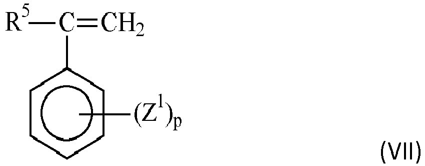 wherein R⁵ is hydrogen, lower alkyl or halogen; Z¹ is vinyl, halogen or lower alkyl; and p is from 0 to about 5. These organic polymers include homopolymers of styrene, chlorostyrene and vinyltoluene, random copolymers of styrene with one or more monomers illustrated by acrylonitrile, butadiene, alpha -methylstyrene, ethylvinylbenzene, divinylbenzene and maleic anhydride, and rubber-modified polystyrenes including blends and grafts, wherein the rubber is a polybutadiene or a rubbery copolymer of about 98 to about 70 wt% styrene and about 2 to about 30 wt% diene monomer. Polystyrenes are miscible with polyphenylene ether in all proportions, and any such blend may contain polystyrene in amounts of about 5 to about 95 wt% and most often about 25 to about 75 wt%, based on the total weight of the polymers.

In an alternative embodiment, the thermoplastic compositions of the present invention include a nylon-based resin, such as a polyamide resin. Polyamides are generally derived from the polymerization of organic lactams having from 4 to 12 carbon atoms. In one embodiment, the lactams are represented by the formula (VIII) 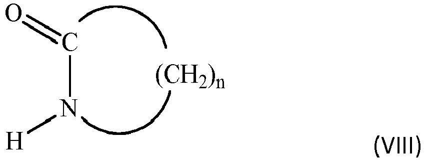 wherein n is 3 to 11. In one embodiment, the lactam is epsilon-caprolactam having n equal to 5.

Polyamides may also be synthesized from amino acids having from 4 to 12 carbon atoms. In one embodiment, the amino acids are represented by the formula (IX) 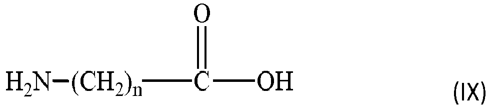 wherein n is 3 to 11. In one embodiment, the amino acid is epsilon-aminocaproic acid with n equal to 5.

Polyamides may also be polymerized from aliphatic dicarboxylic acids having from 4 to 12 carbon atoms and aliphatic diamines having from 2 to 12 carbon atoms. In one embodiment, the aliphatic diamines are represented by the formula (X)

H₂N-(CH₂)ₙ-NH₂ (X)

wherein n is about 2 to about 12. In one embodiment, the aliphatic diamine is hexamethylenediamine (H₂N(CH₂)₆NH₂). In one embodiment, the molar ratio of the dicarboxylic acid to the diamine is from 0.66 to 1.5. Within this range it is generally beneficial to have the molar ratio be greater than or equal to 0.81. In another embodiment, the molar ratio is greater than or equal to 0.96. In yet another embodiment, the molar ratio is less than or equal to 1.22. In still another embodiment, the molar ratio is less than or equal to 1.04. Examples of polyamides that are useful in the present invention include, but are not limited to, nylon 6, nylon 6,6, nylon 4,6, nylon 6, 12, nylon 10, or the like, or combinations including at least one of the foregoing polyamides.

Synthesis of polyamideesters may also be accomplished from aliphatic lactones having from 4 to 12 carbon atoms and aliphatic lactams having from 4 to 12 carbon atoms. The ratio of aliphatic lactone to aliphatic lactam may vary widely depending on the selected composition of the final copolymer, as well as the relative reactivity of the lactone and the lactam. In one embodiment, the initial molar ratio of aliphatic lactam to aliphatic lactone is 0.5 to 4. Within this range a molar ratio of greater than or equal to about 1 is beneficial. In another embodiment, a molar ratio of less than or equal to 2 is utilized.

The conductive precursor composition may further include a catalyst or an initiator. Generally, any known catalyst or initiator suitable for the corresponding thermal polymerization may be used. Alternatively, the polymerization may be conducted without a catalyst or initiator. For example, in the synthesis of polyamides from aliphatic dicarboxylic acids and aliphatic diamines, no catalyst may be used in select embodiments.

For the synthesis of polyamides from lactams, suitable catalysts include water and the omega-amino acids corresponding to the ring-opened (hydrolyzed) lactam used in the synthesis. Other suitable catalysts include metallic aluminum alkylates (MAl(OR)₃H; wherein M is an alkali metal or alkaline earth metal, and R is C₁-C₁₂ alkyl), sodium dihydrobis(2-methoxyethoxy)aluminate, lithium dihydrobis(tert-butoxy)aluminate, aluminum alkylates (Al(OR)₂R; wherein R is C₁-C₁₂ alkyl), N-sodium caprolactam, magnesium chloride or bromide salt of epsilon-caprolactam (MgXC₆H₁₀NO, X=Br or CI), dialkoxy aluminum hydride. Suitable initiators include isophthaloybiscaprolactam, N-acetalcaprolactam, isocyanate epsilon-caprolactam adducts, alcohols (ROH; wherein R is C₁-C₁₂ alkyl), diols (HO-R-OH; wherein R is R is C₁-C₁₂ alkylene), omega-aminocaproic acids, and sodium methoxide.

For the synthesis of polyamideesters from lactones and lactams, suitable catalysts include metal hydride compounds, such as a lithium aluminum hydride catalysts having the formula LiAl(H)ₓ(R¹)_{y}, where x is 1 to 4, y is 0 to 3, x+y is equal to 4, and R¹ is selected from the group consisting of C₁-C₁₂ alkyl and C₁-C₁₂ alkoxy; highly beneficial catalysts include LiAl(H)(OR²)₃, wherein R² is selected from C₁-C₈ alkyl; an especially beneficial catalyst is LiAl(H)(OC(CH₃)₃)₃. Other suitable catalysts and initiators include those described above for the polymerization of poly(epsilon-caprolactam) and poly(epsilon-caprolactone).

In yet another embodiment, the thermoplastic compositions of the present invention include a poly(arylene ether) resin. As used herein, a "poly(arylene ether)" includes a plurality of structural units of the formula (XI): 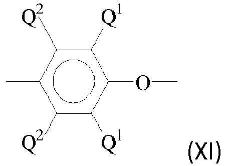 wherein for each structural unit, each Q¹ is independently halogen, primary or secondary lower alkyl (e.g., an alkyl containing 1 to 7 carbon atoms), phenyl, haloalkyl, aminoalkyl, alkenylalkyl, alkynylalkyl, hydrocarbonoxy, and halohydrocarbonoxy wherein at least two carbon atoms separate the halogen and oxygen atoms; and each Q² is independently hydrogen, halogen, primary or secondary lower alkyl, phenyl, haloalkyl, aminoalkyl, alkenylalkyl, alkynylalkyl, hydrocarbonoxy, halohydrocarbonoxy wherein at least two carbon atoms separate the halogen and oxygen atoms. In some embodiments, each Q¹ is independently alkyl or phenyl, for example, C₁₋₄ alkyl, and each Q² is independently hydrogen or methyl. The poly(arylene ether) may include molecules having aminoalkyl-containing end group(s), typically located in an ortho position to the hydroxy group. Also frequently present are 4-hydroxybiphenyl end groups, typically obtained from reaction mixtures in which a by-product diphenoquinone is present.

The poly(arylene ether) may be in the form of a homopolymer; a copolymer; a graft copolymer; an ionomer; a block copolymer, for example comprising arylene ether units and blocks derived from alkenyl aromatic compounds; as well as combinations comprising at least one of the foregoing. Poly(arylene ether) includes polyphenylene ether containing 2,6-dimethyl-1,4-phenylene ether units optionally in combination with 2,3,6-trimethyl-1,4-phenylene ether units.

The poly(arylene ether) may be prepared by the oxidative coupling of monohydroxyaromatic compound(s) such as 2,6-xylenol and/or 2,3,6-trimethylphenol. Catalyst systems are generally employed for such coupling; they can contain heavy metal compound(s) such as a copper, manganese or cobalt compound, usually in combination with various other materials such as a secondary amine, tertiary amine, halide or combination of two or more of the foregoing.

The poly(arylene ether) can have a number average molecular weight of 3,000 to 40,000 atomic mass units (amu) and a weight average molecular weight of 5,000 to 80,000 amu, as determined by gel permeation chromatography. The poly(arylene ether) can have an intrinsic viscosity of 0.10 to 0.60 deciliters per gram (dl/g), or, more specifically, 0.29 to 0.48 dl/g, as measured in chloroform at 25°C. It is possible to utilize a combination of high intrinsic viscosity poly(arylene ether) and a low intrinsic viscosity poly(arylene ether). Determining an exact ratio, when two intrinsic viscosities are used, will depend somewhat on the exact intrinsic viscosities of the poly(arylene ether) used and the ultimate physical properties that are selected.

Examples polyphenylene ether polymers that may be used in the present invention include, but are not limited to, poly(2,6-dimethyl-1,4-phenylene)ether; poly(2,3,6-trimethyl-1,4-phenylene) ether; poly(2,6-diethyl-1,4-phenylene)ether; poly(2-methyl-6-propyl-1,4-phenylene) ether; poly(2,6-dipropyl-1,4-phenylene)ether; poly(2-ethyl-6-propyl-1,4-phenylene)ether; poly(2,6-dilauryl-1,4-phenylene)ether; poly(2,6-diphenyl-1,4-phenylene)ether; poly(2,6-dimethoxy-1,4-phenylene)ether; poly(2,6-diethoxy-1,4-phenylene)ether; poly(2-methoxy-6-ethoxy-1,4-phenylene)ether; poly(2-ethyl-6-stearyloxy-1,4-phenylene)ether; poly(2,6-dichloro-1,4-phenylene)ether; poly(2-methyl-6-phenyl-1,4-phenylene)ether; poly(2,6-dibenzyl-1,4-phenylene)ether; poly(2-ethoxy-1,4-phenylene)ether; poly(2-chloro-1,4-phenylene) ether; poly(2,6-dibromo-1,4-phenylene)ether; poly(3-bromo-2,6-dimethyl-1,4-phenylene)ether, copolymers thereof and mixtures thereof, and the like. In select embodiments, polyphenylene ether polymers for use in the compositions of the present invention include poly(2,6-dimethyl-1,4-phenylene) ether, poly(2,3,6-trimethyl-1,4-phenylene)ether, blends of these polymers and copolymers including units of 2,3,6-trimethyl-1,4-phenylene ether and units of 2,6-dimethyl-1,4-phenylene ether. Examples of such polymers and copolymers are also set forth in U.S. Pat. No. 4,806,297.

In yet another embodiment, the thermoplastic compositions of the present invention include a polyphthalamide resin. The polyphthalamide, in one embodiment, includes the reaction product of (i) hexamethylene diamine or a mixture of hexamethylene diamine and trimethyl hexamethylene diamine, and (ii) terephthalic acid, and optionally (iii) at least one acid selected from isophthalic acid or adipic acid, provided that a mixture of the diamines is employed if reactant (iii) is absent. These polyphthalamides are generally crystalline in nature and exhibit improved tensile strength and high heat deflection temperatures. These polyphthalamides, and methods for their preparation, are disclosed in U.S. Pat. Nos. 4,603,166 and 4,617,342, and in European Patent Applications Nos. 121,983, 121,984, 121,985, 122,688 and 395,414.

For example, U.S. Pat. No. 4,603,166 and European Patent Application No. 121,984 disclose polyphthalamides prepared from hexamethylene diamine, terephthalic acid and adipic acid and from hexamethylene diamine, terephthalic acid, isophthalic acid and adipic acid. The hexamethylene diamine: terephthalic acid: isophthalic acid: adipic acid mole ratio employed therein is in the range of about 100:65-95:25-0:35-5. U.S. Pat. No. 4,617,342 and European Patent Application No. 122,688 disclose polyphthalamides formed from a mixture of hexamethylene diamine and trimethyl hexamethylene diamine in a molar ratio of from about 98:2 to about 60:4 and a mixture of terephthalic acid and isophthalic acid in a molar ratio of at least 80:20 to about 99:1. European Patent Application No. 121,985 discloses polyphthalamides prepared from a mixture of hexamethylene diamine and trimethyl hexamethylene diamine in a mole ratio of from about 55/45 to about 95/5 and terephthalic acid. The mole ratio of the terephthalic acid to the diamines is preferably in the range of 1.2:1 to 1:1.2, and more preferably about 1:1. European Patent Application No. 121,983 discloses polyphthalamides prepared from mixtures of hexamethylene diamine and trimethyl hexamethylene diamine and mixtures of terephthalic acid and adipic acid or mixtures of terephthalic acid, isophthalic acid and adipic acid. The mole ratio of hexamethylene diamine to trimethyl hexamethylene diamine is in the range of about 55/45 to about 98/2. When a mixture of terephthalic acid and adipic acid is employed, the mole ratio of the diamines, terephthalic acid and adipic acid is in the range of about 100/61/39 to 100/95/5. When the mixture of terephthalic acid, isophthalic acid and adipic acid is employed, the mole ratio of the diamines, terephthalic acid and a mixture of isophthalic acid and adipic acid is in the range of about 100/61/39 to 100/95/5, with the molar ratio of isophthalic acid to adipic acid in the mixture being about 38/1 to 1/38. Any of these crystalline polyphthalamides are suitable for use in the compositions of the present invention and may be prepared in accordance with the teachings of the aforementioned Poppe et al U.S. patents and the cited European patent applications.

The amount of the thermoplastic resin used in the thermoplastic compositions of the present invention may be based on the selected properties of the thermoplastic compositions as well as molded articles made from these compositions. Other factors include the type and/or amount of the LDS additive used and/or the type and/or amount of the colorant used. In one embodiment, the thermoplastic resin is present in amounts of from 60 to 99.5 wt.%. In another embodiment, the thermoplastic resin is present in amounts from 65 to 95 wt.%. In still another embodiment, the thermoplastic resin is present in amounts from 70 to 90 wt.%.

In addition to the thermoplastic resin, the compositions of the present invention also include a laser direct structuring (LDS) additive. The LDS additive is selected to enable the composition to be used in a laser direct structuring process. In an LDS process, a laser beam exposes the LDS additive to place it at the surface of the thermoplastic composition and to activate metal atoms from the LDS additive. As such, the LDS additive is selected such that, upon exposed to a laser beam, metal atoms are activated and exposed and in areas not exposed by the laser beam, no metal atoms are exposed. In addition, the LDS additive is selected such that, after being exposed to laser beam, the etching area is capable of being plated to form conductive structure. As used herein "capable of being plated" refers to a material wherein a substantially uniform metal plating layer can be plated on laser-etched area and show a wide window for laser parameters. This process is different than laser marking wherein the main outcome of laser marking is a color change in the material under the effect of energy radiation. And the key characterization for laser marking is the contrast between the mark and the substrate.

Conversely, for LDS, the goal is the formation of metal seeds on the laser etched surface, and the final metallization layer during the following plating process. Plating rate and adhesion of plated layers are the key evaluation requirements. Color here means the substrate made from these materials itself not the color change under the laser radiation. As such, in addition to enabling the composition to be used in a laser direct structuring process, the LDS additive used in the present invention is also selected to help enable the composition to be colored while maintaining physical properties.

As previously discussed, current additives for LDS materials are usually spinel based metal oxides (such as copper chromium oxide), organic metal complexes (such as palladium/palladium-containing heavy metal complexes) or copper complexes there are some limitations based on these additives. However, spinel based metal oxides result in a black color. In addition, with organic metal complex, higher loadings are needed to obtain sufficiently dense nucleation for rapid metallization when activated, and these higher amounts adversely affect the mechanical properties of the materials.

Accordingly, the present invention utilizes LDS additives that enable coloring of the material while retaining mechanical strength of the composition. Examples of LDS additives useful in the present invention include, but are not limited to, metal oxides, metal oxide-coated fillers or a combination including at least one of the foregoing LDS additives. In one embodiment of the present invention, the LDS additive is antimony doped tin oxide coating on a mica substrate. Other examples include a coating including a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxides, and the substrate may be any other mineral, such as silica. In an alternative embodiment of the present invention, the LDS additive is tin oxide. Other examples include a zinc containing metal oxide, a tin containing metal oxide, an aluminum containing metal oxide, , or a combination including at least one of the foregoing metal oxides.

The amount of the LDS additive included is sufficient to enable plating of the track formed after activation by the laser while not adversely affecting mechanical properties. In one embodiment, the LDS additive is present in amounts of from 0.5 to 20 wt.%. In another embodiment, the LDS additive is present in amounts from 1 to 15 wt.%. In still another embodiment, the LDS additive is present in amounts from 3 to 10 wt.%.

As discussed, the LDS additive is selected such that, after activating with a laser, the conductive path can be formed by followed a standard electroless plating process. When the LDS additive is exposed to the laser, elemental metal is released. The laser draws the circuit pattern onto the part and leaves behind a roughened surface containing embedded metal particles. These particles act as nuclei for the crystal growth during a subsequent plating process, such as a copper plating process. Other electroless plating processes that may be used include, but are not limited to, gold plating, nickel plating, silver plating, zinc plating, tin plating or the like.

In addition to the thermoplastic resin and the LDS additive, the compositions of the present invention optionally include a pigment, dye or colorant. By using a metal oxide or metal oxide coated substrate, the resulting compositions are much lighter in color than those made using a spinel based metal oxide. The result is a composition capable of being colored. Now, a colorant, dye or pigment is not required if the "natural" color of the composition is preferred. However, due to the lighter natural color of the compositions of the present invention, should a colored composition be preferred, the pigment, dye or colorant may be added.

Suitable pigments include for example, inorganic pigments such as metal oxides and mixed metal oxides such as zinc oxide, titanium dioxides, BaSO4, CaCO3, BaTiO3 iron oxides or the like; sulfides such as zinc sulfides, or the like; aluminates; sodium sulfo-silicates; sulfates and chromates; carbon blacks; zinc ferrites; ultramarine blue; Pigment Brown 24; Pigment Red 101; Pigment Yellow 119; Pigment black 28; organic pigments such as azos, di-azos, quinacridones, perylenes, naphthalene tetracarboxylic acids, flavanthrones, isoindolinones, tetrachloroisoindolinones, anthraquinones, anthanthrones, dioxazines, phthalocyanines, and azo lakes; Pigment Blue 60, Pigment Red 122, Pigment Red 149, Pigment Red 177, Pigment Red 179, Pigment Red 202, Pigment Violet 29, Pigment Blue 15, Pigment Green 7, Pigment Yellow 147 and Pigment Yellow 150, or combinations including at least one of the foregoing pigments. Any pigments are generally used in amounts of from 1 to 10 parts by weight, based on 100 parts by weight based on 100 parts by weight of the total composition.

Suitable dyes include, for example, organic dyes such as coumarin 460 (blue), coumarin 6 (green), nile red or the like; lanthanide complexes; hydrocarbon and substituted hydrocarbon dyes; polycyclic aromatic hydrocarbons; scintillation dyes (preferably oxazoles and oxadiazoles); aryl- or heteroaryl-substituted poly (2-8 olefins); carbocyanine dyes; phthalocyanine dyes and pigments; oxazine dyes; carbostyryl dyes; porphyrin dyes; acridine dyes; anthraquinone dyes; arylmethane dyes; azo dyes; diazonium dyes; nitro dyes; quinone imine dyes; tetrazolium dyes; thiazole dyes; perylene dyes, perinone dyes; bis-benzoxazolylthiophene (BBOT); and xanthene dyes; fluorophores such as anti- stokes shift dyes which absorb in the near infrared wavelength and emit in the visible wavelength, or the like; luminescent dyes such as 5-amino-9-diethyliminobenzo(a)phenoxazonium perchlorate; 7-amino-4-methylcarbostyryl; 7-amino-4-methylcoumarin; 3-(2'-benzimidazolyl)-7-N,N-diethylaminocoumarin; 3-(2'-benzothiazolyl)-7-diethylaminocoumarin; 2-(4-biphenylyl)-5-(4-t-butylphenyl)-1,3,4-oxadiazole; 2-(4-biphenyl)-6-phenylbenzoxazole-1,3; 2,5-Bis-(4-biphenylyl)-1,3,4-oxadiazole; 2,5-bis-(4-biphenylyl)-oxazole; 4,4'-bis-(2-butyloctyloxy)-p-quaterphenyl; p-bis(o-methylstyryl)-benzene; 5,9-diaminobenzo(a)phenoxazonium perchlorate; 4-dicyanomethylene-2-methyl-6-(p-dimethylaminostyryl)-4H-pyran; 1,1'-diethyl-2,2'-carbocyanine iodide; 3,3'-diethyl-4,4',5,5'-dibenzothiatricarbocyanine iodide; 7-diethylamino-4-methylcoumarin; 7-diethylamino-4-trifluoromethylcoumarin; 2,2'-dimethyl-p-quaterphenyl; 2,2-dimethyl-p-terphenyl; 7-ethylamino-6-methyl-4-trifluoromethylcoumarin; 7-ethylamino-4-trifluoromethylcoumarin; nile red; rhodamine 700; oxazine 750; rhodamine 800; IR 125; IR 144; IR 140; IR 132; IR 26; IR5; diphenylhexatriene; diphenylbutadiene; tetraphenylbutadiene; naphthalene; anthracene; 9,10-diphenylanthracene; pyrene; chrysene; rubrene; coronene; phenanthrene or the like, or combinations including at least one of the foregoing dyes. Any dyes are generally used in amounts of from 0.1 to 5 parts by weight, based on 100 parts by weight of the total composition.

Suitable colorants include, for example titanium dioxide, anthraquinones, perylenes, perinones, indanthrones, quinacridones, xanthenes, oxazines, oxazolines, thioxanthenes, indigoids, thioindigoids, naphthalimides, cyanines, xanthenes, methines, lactones, coumarins, bis-benzoxazolylthiophene (BBOT), napthalenetetracarboxylic derivatives, monoazo and disazo pigments, triarylmethanes, aminoketones, bis(styryl)biphenyl derivatives, and the like, as well as combinations including at least one of the foregoing colorants. Any colorants are generally used in amounts of from 0.1 to 5 parts by weight, based on 100 parts by weight of the total composition, excluding any filler.

As discussed, while colorants or dyes or pigments may be used in the present invention, they are not required. These colorants may be used because the natural color of the composition is much lighter than previous LDS compositions using an LDS additive that resulted in a composition that was black, or close to black, such that no colorant may have been effective. Accordingly, the compositions of the present invention have, in one embodiment, an L* value of 40 to 85. In an alternative embodiment, the compositions of the present invention have, in one embodiment, an L* value of 45 to 80. In yet another alternative embodiment, the compositions of the present invention have, in one embodiment, an L* value of 50 to 75. The "L* value" describes the lightness-darkness property. If the L* value = 0, the object is black. If the L* value = 100 the object is white. The L* value is always positive. Compositions having an L* value further away from the extremes (0 and 100) have a more natural color, which may be the selected color for a specific application or which may enable the composition to be more easily colored. L* is measured using ASTM 2244 with 10 degree observer; D65 illuminant; SCI reflectance; and large aperture). The compositions having a L* of 40 to 85 results in the compositions having color space that could be achieved based on this light color naturally in the range of from 28 to 94. As used herein, the L* of the material naturally is the value of material without any colorant. Having values further away from 0 for L* results in a composition that has a much wider "color space". The "color space" is the range of L* that can be achieved using an optional colorant, pigment and/or dye. The compositions of the present invention have a much larger color space as compared to prior art LDS compositions, such that the compositions of the present invention are colorable.

The color properties of the composition may also be defined using the a* and b* values. The a* value describes the position on a red-green axis. If a* is positive, the shade is red and if a* is negative, the shade is green. The b* value describes the position on a yellow-blue axis. If b* is positive, the shade is yellow and if b* is negative, the shade is blue. When a* and b* are near zero and L is bigger, the result is a lighter color for the composition. For compositions of the present invention, it is beneficial for the a* and b* values naturally occurring in the compositions to be closer to zero since, as before, this enables a much larger color space to be achieved. In one embodiment, the compositions have an a* value of from -1 to -5 and a b* value of from -5 to 20. This results in a color space capable of being achieved by the compositions of -50 to 52 for a* and -40 to 80 for b*. Again, as may be seen, since the compositions of the present invention utilize an LDS additive that is not darker in nature, a much wider array of color possibilities is possible. ASTM 2244 is also used to determine a* and b* values.

In addition to the thermoplastic resin, the LDS additive, and the optional colorant, the thermoplastic compositions of the present invention may include various additives ordinarily incorporated in resin compositions of this type. Mixtures of additives may be used. Such additives may be mixed at a suitable time during the mixing of the components for forming the composition. The one or more additives are included in the thermoplastic compositions to impart one or more selected characteristics to the thermoplastic compositions and any molded article made therefrom. Examples of additives that may be included in the present invention include, but are not limited to, heat stabilizers, process stabilizers, antioxidants, light stabilizers, plasticizers, antistatic agents, mold releasing agents, UV absorbers, lubricants, flow promoters or a combination of one or more of the foregoing additives. Any additive that would not adversely affect the colorability of the final composition may be included.

Suitable heat stabilizers include, for example, organo phosphites such as triphenyl phosphite, tris-(2,6-dimethylphenyl)phosphite, tris-(mixed mono-and dinonylphenyl)phosphite or the like; phosphonates such as dimethylbenzene phosphonate or the like, phosphates such as trimethyl phosphate, or the like, or combinations including at least one of the foregoing heat stabilizers. Heat stabilizers are generally used in amounts of from 0.01 to 0.5 parts by weight based on 100 parts by weight of the total composition, excluding any filler.

Suitable antioxidants include, for example, organophosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di-tert-butyl-4-hydroxyhydrocinnamate)] methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate or the like; amides of beta-(3,5-di-tert-butyl-4-hydroxyphenyl)-propionic acid or the like, or combinations including at least one of the foregoing antioxidants. Antioxidants are generally used in amounts of from 0.01 to 0.5 parts by weight, based on 100 parts by weight of the total composition, excluding any filler.

Suitable light stabilizers include, for example, benzotriazoles such as 2-(2-hydroxy-5-methylphenyl)benzotriazole, 2-(2-hydroxy-5-tert-octylphenyl)-benzotriazole and 2-hydroxy-4-n-octoxy benzophenone or the like or combinations including at least one of the foregoing light stabilizers. Light stabilizers are generally used in amounts of from 0.1 to 1.0 parts by weight, based on 100 parts by weight of the total composition, excluding any filler.

Suitable plasticizers include, for example, phthalic acid esters such as dioctyl-4,5-epoxy-hexahydrophthalate, tris-(octoxycarbonylethyl) isocyanurate, tristearin, epoxidized soybean oil or the like, or combinations including at least one of the foregoing plasticizers. Plasticizers are generally used in amounts of from 0.5 to 3.0 parts by weight, based on 100 parts by weight of the total composition, excluding any filler.

Suitable antistatic agents include, for example, glycerol monostearate, sodium stearyl sulfonate, sodium dodecylbenzenesulfonate or the like, or combinations of the foregoing antistatic agents. In one embodiment, carbon fibers, carbon nanofibers, carbon nanotubes, carbon black, or any combination of the foregoing may be used in a polymeric resin containing chemical antistatic agents to render the composition electrostatically dissipative.

Suitable mold releasing agents include for example, metal stearate, stearyl stearate, pentaerythritol tetrastearate, beeswax, montan wax, paraffin wax, or the like, or combinations including at least one of the foregoing mold release agents. Mold releasing agents are generally used in amounts of from 0.1 to 1.0 parts by weight, based on 100 parts by weight of the total composition, excluding any filler.

Suitable UV absorbers include for example, hydroxybenzophenones; hydroxybenzotriazoles; hydroxybenzotriazines; cyanoacrylates; oxanilides; benzoxazinones; 2- (2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]- 5-(octyloxy)-phenol (CYASORB™ 1164); 2,2'-(1,4- phenylene)bis(4H-3,1-benzoxazin-4-one) (CYASORB™ UV- 3638); 1,3-bis[(2-cyano-3,3-diphenylacryloyl)oxy]-2,2-bis[[(2-cyano-3, 3-diphenylacryloyl)oxy]methyl]propane (UVINUL™ 3030); 2,2'-(1,4-phenylene) bis(4H-3,1-benzoxazin-4-one); 1,3-bis[(2-cyano-3,3-diphenylacryloyl)oxy] -2,2-bis[[(2-cyano-3,3-diphenylacryloyl)oxy]methyl]propane; nano-size inorganic materials such as titanium oxide, cerium oxide, and zinc oxide, all with particle size less than 100 nanometers; or the like, or combinations including at least one of the foregoing UV absorbers. UV absorbers are generally used in amounts of from 0.01 to 3.0 parts by weight, based on 100 parts by weight based on 100 parts by weight of the total composition, excluding any filler.

Suitable lubricants include for example, fatty acid esters such as alkyl stearyl esters, e.g., methyl stearate or the like; mixtures of methyl stearate and hydrophilic and hydrophobic surfactants including polyethylene glycol polymers, polypropylene glycol polymers, and copolymers thereof e.g., methyl stearate and polyethylene-polypropylene glycol copolymers in a suitable solvent; or combinations including at least one of the foregoing lubricants. Lubricants are generally used in amounts of from 0.1 to 5 parts by weight, based on 100 parts by weight of the total composition, excluding any filler.

Suitable blowing agents include for example, low boiling halohydrocarbons and those that generate carbon dioxide; blowing agents that are solid at room temperature and when heated to temperatures higher than their decomposition temperature, generate gases such as nitrogen, carbon dioxide, ammonia gas, such as azodicarbonamide, metal salts of azodicarbonamide, 4,4' oxybis(benzenesulfonylhydrazide), sodium bicarbonate, ammonium carbonate, or the like, or combinations including at least one of the foregoing blowing agents. Blowing agents are generally used in amounts of from 1 to 20 parts by weight, based on 100 parts by weight of the total composition, excluding any filler.

Additionally, materials to improve flow and other properties may be added to the composition, such as low molecular weight hydrocarbon resins. Particularly useful classes of low molecular weight hydrocarbon resins are those derived from petroleum C₅ to C₉ feedstock that are derived from unsaturated C₅ to C₉ monomers obtained from petroleum cracking. Non-limiting examples include olefins, e.g. pentenes, hexenes, heptenes and the like; diolefins, e.g. pentadienes, hexadienes and the like; cyclic olefins and diolefins, e.g. cyclopentene, cyclopentadiene, cyclohexene, cyclohexadiene, methyl cyclopentadiene and the like; cyclic diolefin dienes, e.g., dicyclopentadiene, methylcyclopentadiene dimer and the like; and aromatic hydrocarbons, e.g. vinyltoluenes, indenes, methylindenes and the like. The resins can additionally be partially or fully hydrogenated.

The thermoplastic compositions of the present invention may be formed using any known method of combining multiple components to form a thermoplastic resin. In one embodiment, the components are first blended in a highspeed mixer. Other low shear processes including but not limited to hand mixing may also accomplish this blending. The blend is then fed into the throat of a twin-screw extruder via a hopper. Alternatively, one or more of the components may be incorporated into the composition by feeding directly into the extruder at the throat and/or downstream through a sidestuffer. The extruder is generally operated at a temperature higher than that necessary to cause the composition to flow. The extrudate is immediately quenched in a water batch and pelletized. The pellets so prepared when cutting the extrudate may be one-fourth inch long or less as desired. Such pellets may be used for subsequent molding, shaping, or forming.

Shaped, formed, or molded articles including the thermoplastic compositions are also provided. The thermoplastic compositions can be molded into useful shaped articles by a variety of means such as injection molding, extrusion, rotational molding, blow molding and thermoforming to form articles such as, for example, personal computers, notebook and portable computers, cell phone antennas and other such communications equipment, medical applications, RFID applications, automotive applications, and the like.

In one embodiment, the present invention includes a molded article having a conductive path onto which has been plated a metal layer. In one embodiment, the metal layer has a peel strength of 0.3 N/mm or higher. In another embodiment, the metal layer has a peel strength of 0.7 N/mm or higher. In still another embodiment, the metal layer has a peel strength of 0.8 N/mm or higher.

The present invention is further illustrated by the following non-limiting examples.

### EXAMPLES

In these examples, the effects of an LDS additive on the color of a polymer composition were examined. In these examples, the polymer base resin was a polycarbonate/acrylonitrile-butadiene-styrene resin blend (available from SABIC Innovative Plastics) and the metal oxide-coated filler was antimony-doped tin oxide (available from Merck Chemicals (Shanghai) Co., Ltd.). Varying amounts of the antimony-doped tin oxide were used (from 0.5 to 10 wt%). A comparative example showing the use of a standard LDS additive was performed using a copper chromium oxide spinel (available from Ferro Taiwan). 3.46 wt% of additional additives were used in all examples and included talc (available from Hayashi Kasei Co. Ltd.), a hindered phenol anti-oxidant, a phosphite stabilizer and a metal deactivitor (all three available from Ciba Specialty Chemicals (China) Ltd.) and Aclyn 295 ethylene-acrylic acid zinc ionomers (available from Honeywell). The effects of the two LDS additives on the color and impact strength may be seen in Table 1.

**Table 1**

| Formulation | | A | B | C | D | E | F (black) |
|---|---|---|---|---|---|---|---|
| PC/ABS | % | 86.54 | 88.54 | 91.54 | 93.54 | 96.04 | 86.54 |
| Mica coated with (Sn/Sb)O2 | % | 10 | 8 | 5 | 3 | 0.5 | |
| Copper chromium oxide | | | | | | | 10 |
| Others | % | 3.46 | 3.46 | 3.46 | 3.46 | 3.46 | 3.46 |
| L* | | 60.3 | 63.9 | 64.9 | 67.1 | 76.4 | 29 |
| a* | | -4.6 | -4.4 | -4.3 | -4.1 | -3.3 | 0.1 |
| b* | | -4.1 | -1.3 | -0.4 | 0.8 | 4.7 | -1.1 |
| Impact strength | J/m | 500 | 540 | 570 | 600 | 670 | 530 |

As may be seen, the use of the antimony-doped tin oxide resulted in a composition having a much higher L* value (indicating much closer to white) as compared to the copper chromium oxide spinel. As a result, different color shading could be detected in these materials as compared to the copper chromium oxide spinel example. The result was compositions that had the ability to be colored. And, the compositions of the present invention still maintained good mechanical properties and the ability to be activated using an LDS process and plated.

**Table 2**

| Sample | A | D |
|---|---|---|
| Laser condition (Laser power/pulse) | 8W/60KHz | 10W/100KHz |
| Peel strength (N/mm) | 0.92 | 1.30 |

In Table 2, it can be seen that even with different LDS additive loadings at 10% (Formulation A) and 3% (Formulation D), it was possible to obtain good laser and plating performance as seen by the higher peel strength values. Adhesion of the copper layer was determined by testing the peel strength using a peel test machine. The test method used was IPC-TM-650. In this standard, the laser power was 5W, the laser pulse was 60KHz, the laser speed was 2m/s, the plated copper layer thickness was 30∼35um and the peel speed was 50mm/min.

In the next examples, the ability of the compositions to be colored is shown. In these examples, 5 wt% of a white pigment (TiO2 available from DuPont) was used. The results are shown in Table 3.

**Table 3**

| Formulation | | G | H |
|---|---|---|---|
| PC/ABS | % | 86.54 | 81.54 |
| Mica coated with (Sn/Sb)O2 | % | 5 | |
| Copper chromium oxide | | | 10 |
| TiO2 | | 5 | 5 |
| Others | % | 3.46 | 3.46 |
| L* | | 87.3 | 40.3 |
| a* | | -2.2 | -0.3 |
| b* | | 1.1 | -5.9 |
| Impact strength | J/m | 480 | 420 |

As may be seen, the composition using the antimony-doped tin oxide had a color much closer to white (higher L* value) and the copper chromium oxide spinel example had a color closer to black than even those antimony-doped tin oxide examples using no white pigment (Examples A-E above). The antimony-doped tin oxide example even exhibited better impact strength will maintaining the ability to be plated using an LDS process.

The next set of examples show that a wide array of colors may be obtained using compositions of the present invention. As discussed, prior art LDS additives result in compositions having low L* values such that the resulting compositions could not be colored to achieve a wide array of colors. In Table 4, though, the data shows that due to the light natural color of the base composition, when different colorants were added into the formulations, a wide array of L*, a* and b* values can be obtained.

**Table 4**

| Sample | | I | J | K | L | M | N |
|---|---|---|---|---|---|---|---|
| PC/ABS | | 87.54 | 87.54 | 87.54 | 87.54 | 81.54 | 86.54 |
| Mica coated with (Sn/Sb)O2 | % | 5 | 5 | 5 | 5 | 5 | 5 |
| Coated TiO2 | % | 3 | 3 | 3 | 3 | 10 | |
| Disperse Yellow 201 | % | 1 | | | | | |
| Pigment Blue 15:4 | % | | 1 | | | | |
| Pigment Red 178 | % | | | 1 | | | |
| Pigment Green 7 | % | | | | 1 | | |
| Pigment black 28 | % | | | | | | 5 |
| Others | % | 3.46 | 3.46 | 3.46 | 3.46 | 3.46 | 3.46 |
| L-Avg | - | 80.9 | 48.6 | 51.1 | 57 | 90.6 | 31.6 |
| a-Avg | - | -11.7 | -14.4 | 43.5 | -44.7 | -1.8 | -0.4 |
| b-Avg | - | 73.6 | -36.8 | 11.9 | 0.6 | 1 | -3 |
| Impact Strength | J/m | 420 | 389 | 397 | 417 | 430 | 370 |

In Table 5, it may be seen that in addition to being able to provide a colorable LDS material, but these materials also exhibit very good laser etching and plating performance. This was shown by the peel strength value, which showed very good adhesion of copper layer to the article made from the colorable materials.

**Table 5**

| Sample | I | J | K | L | M | N |
|---|---|---|---|---|---|---|
| Laser condition (Laser power/Laser pulse) | 5W/40KHz | 6W/60KHz | 8W/80KHz | 10W/60KHz | 6W/60KHz | 8W/80KHz |
| Peel strength (N/mm) | 0.90 | 1.1 | 1.15 | 1.04 | 0.90 | 0.83 |

The last set of examples showed that the use of tin oxide as an LDS additive resulted in colorable compositions that still had excellent mechanical properties as compared to prior art LDS compositions. These materials exhibited better thermal stability than general LDS additives and had excellent impact strength under room and low temperatures. As such, it may be seen that metal oxides are also useful as LDS additives. The results may be seen in Table 6.

**Table 6**

| Sample | % | Comp. Ex. 1 | Comp. Ex. 2 | 2% SnO2 | 4% SnO2 |
|---|---|---|---|---|---|
| PC | % | 82.5 | 71 | 79 | 77 |
| EXL PC | % | 17.5 | 15 | 15 | 15 |
| LDS additives | % | -- | 10 | | |
| Tin oxide | % | -- | -- | 2 | 4 |
| Talc | % | -- | 3 | 3 | 3 |
| Quencher | % | -- | 0.24 | 0.24 | 0.24 |
| Others | % | 0.03 | 0.76 | 0.76 | 0.76 |
| MVR, 300C, 1.2 Kg, 360s | cm³/10 min | 9 | 7 | 8 | 8 |
| Density | g/cm3 | 1.18 | 1.29 | 1.22 | 1.24 |
| Mw (pellets) | Daltons | -- | 59643 | 59239 | 59537 |
| Mw (Izod part) | Daltons | -- | 56367 | 57572 | 58548 |
| Notched Impact Strength, 23C | J/m | 865 | 888 | 1020 | 952 |
| Notched Impact Strength, -20C | J/m | 774 | 740 | 694 | 933 |
| HDT, 1.82MPa, 3.2 mm | °C | 124 | 126 | 127 | 127 |
| Flexural Modulus | MPa | 2230 | 2360 | 2290 | 2330 |
| Flexural Stress@Yield | MPa | 92 | 85 | 86.9 | 86.6 |
| Modulus of Elasticity | MPa | 2150 | 2494 | 2410.8 | 2416.4 |
| Stress at Yield | MPa | 57 | 55 | 57.1 | 56.3 |
| Elongation at Break | % | 120 | 48 | 35.3 | 68.6 |

In one embodiment, a thermoplastic composition consists essentially of: a) 75 to 99.5% by weight of a thermoplastic base resin; and b) 0.5 to 25% by weight of a filler selected from a metal oxide, a metal oxide coated filler, or a combination thereof. The thermoplastic compositions are capable of being plated after being activated using a laser. The compositions have a L* value as determined by ASTM 2244 of 40 to 85, an a* value as determined by ASTM 2244, of -1 to -5, and a b* value as determined by ASTM 2244 of -5 to 20.

In another embodiment, a thermoplastic composition consists essentially of: a) 70 to 99.4% by weight of a thermoplastic base resin; b) 0.5 to 20% by weight of a metal oxide coated filler; and c) 0.1 to 10% by weight of at least one dye, pigment, colorant or a combination including at least one of the foregoing. The thermoplastic compositions are capable of being plated after being activated using a laser. The thermoplastic compositions have a color space defined by a L* value as determined by ASTM 2244 of 28 to 94, an a* value as determined by ASTM 2244 of -50 to 52; and b* value as determined by ASTM 2244 of -40 to 80.

In one embodiment, a thermoplastic composition consists of: a) 75 to 99.5% by weight of a thermoplastic base resin; and b) 0.5 to 25% by weight of a filler selected from a metal oxide, a metal oxide coated filler, or a combination thereof. The thermoplastic compositions are capable of being plated after being activated using a laser. The compositions have a L* value as determined by ASTM 2244 of 40 to 85, an a* value as determined by ASTM 2244, of -1 to -5, and a b* value as determined by ASTM 2244 of -5 to 20.

In another embodiment, a thermoplastic composition consists of: a) 70 to 99.4% by weight of a thermoplastic base resin; b) 0.5 to 20% by weight of a metal oxide coated filler; and c) 0.1 to 10% by weight of at least one dye, pigment, colorant or a combination including at least one of the foregoing. The thermoplastic compositions are capable of being plated after being activated using a laser. The thermoplastic compositions have a color space defined by a L* value as determined by ASTM 2244 of 28 to 94, an a* value as determined by ASTM 2244 of -50 to 52; and b* value as determined by ASTM 2244 of -40 to 80.

In the various embodiments, (i) the metal oxide can be selected from tin oxide, a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxides; and/or (ii) the thermoplastic compositions have a color space defined by a L* value as determined by ASTM 2244 from 30 to 91; and/or (iii) the thermoplastic base resin can be selected from polycarbonate, a polycarbonate/acrylonitrile-butadiene-styrene resin blend; a poly(arylene ether) resin, a nylon-based resin, a polyphthalamide resin, a polyphenylene oxide resin or a combination including at least one of the foregoing resins; and/or (iv)the filler is a the metal oxide coated filler, and the metal oxide coated filler includes a metal oxide coating that is selected from an antimony doped tin oxide, a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxide; and/or (v) the filler is a metal oxide coated filler, and the metal oxide coated filler includes a substrate selected from mica, silica or a combination including at least one of the foregoing substrates; and/or (vi) the filler is a metal oxide selected from a zinc containing metal oxide, a tin containing metal oxide, an aluminum containing metal oxide, or a combination including at least one of the foregoing metal oxides.

In one embodiment, an article of manufacture comprises: a molded article having a conductive path thereon and a metal layer plated on the conductive path. The metal layer has a peel strength of 0.3 N/mm or higher as measured according to IPC-TM-650. Furthermore, the molded article is formed from any of the above compositions.

In the various embodiments, (i) the article is selected from a computer, a cell phone, communications equipment, a medical application, an RFID application, or an automotive application; and/or (ii) the metal layer comprises a copper layer; and/or (iii) the metal layer has a peel strength of 0.7 N/mm or higher as measured according to IPC-TM-650.

In one embodiment, a method of forming an article comprises the steps of: molding an article from any of the above compositions; using a laser to form a conductive path on the molded article; and plating a copper layer onto the conductive path. The copper layer has a peel strength of 0.3 N/mm or higher as measured according to IPC-TM-650.

## Claims

1. A thermoplastic composition, consisting essentially of:
a) 75 to 99.5% by weight of a thermoplastic base resin; and
b) 1 to 15% by weight of a laser direct structuring additive selected from a metal oxide, a metal oxide coated filler, or a combination thereof, wherein the metal oxide is selected from tin oxide, a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxides, and the metal oxide coated filler includes a metal oxide coating that is selected from an antimony doped tin oxide, a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxides;
wherein the thermoplastic compositions are capable of being plated after being activated using a laser;
wherein the compositions have a L* value as determined by ASTM 2244 of 40 to 85, wherein the compositions have an a* value as determined by ASTM 2244, of -1 to -5, and wherein the compositions have a b* value as determined by ASTM 2244 of -5 to 20.

2. A thermoplastic composition, consisting essentially of:
a) 70 to 99.4% by weight of a thermoplastic base resin;
b) 1 to 15% by weight of a laser direct structuring (LDS) additive, wherein the LDS additive is a metal oxide coated filler, wherein the metal oxide coated filler includes a metal oxide coating that is selected from an antimony doped tin oxide, a copper containing metal oxide, a zinc containing metal oxide, a tin containing metal oxide, a magnesium containing metal oxide, an aluminum containing metal oxide, a gold containing metal oxide, a silver containing metal oxide, or a combination including at least one of the foregoing metal oxides; and
c) 1 to 15% by weight of at least one dye, pigment, colorant or a combination including at least one of the foregoing;
wherein the thermoplastic compositions are capable of being plated after being activated using a laser;
wherein the thermoplastic compositions have a color space defined by a L* value as determined by ASTM 2244 of 28 to 94, an a* value as determined by ASTM 2244 of -50 to 52; and b* value as determined by ASTM 2244 of -40 to 80.

3. The thermoplastic composition of Claim 2, wherein the thermoplastic compositions have a color space defined by a L* value as determined by ASTM 2244 from 30 to 91.

4. The thermoplastic composition of any of Claims 1 - 3, wherein the thermoplastic base resin is selected from polycarbonate, a polycarbonate/acrylonitrile-butadiene-styrene resin blend; a poly(arylene ether) resin, a nylon-based resin, a polyphthalamide resin, a polyphenylene oxide resin or a combination including at least one of the foregoing resins.

5. The thermoplastic composition of any of Claims 1 - 4, wherein metal oxide coated filler includes a substrate selected from mica, silica or a combination including at least one of the foregoing substrates.

6. The thermoplastic composition of any of Claims 1 - 5, wherein the metal oxide is selected from a zinc containing metal oxide, a tin containing metal oxide, an aluminum containing metal oxide, or a combination including at least one of the foregoing metal oxides.

7. An article of manufacture comprising:
a molded article having a conductive path thereon;
a metal layer plated on the conductive path;
wherein the metal layer has a peel strength of 0.3 N/mm or higher as measured according to IPC-TM-650;
further wherein the molded article is formed from the composition of any of Claims 1 - 6.

8. The article of Claim 7, wherein the article is selected from a computer, a cell phone, communications equipment, a medical application, an RFID application, or an automotive application.

9. The article of any of Claims 7-8, wherein the metal layer comprises a copper layer.

10. The article of any of Claims 7-9, wherein the metal layer has a peel strength of 0.7 N/mm or higher as measured according to IPC-TM-650.

11. A method of forming an article comprising the steps of:
molding an article from the composition of any of Claims 1 - 6;
using a laser to form a conductive path on the molded article; and
plating a copper layer onto the conductive path;
wherein the copper layer has a peel strength of 0.3 N/mm or higher as measured according to IPC-TM-650.
